# EUROPEAN PATENT APPLICATION

(11) **EP 3 228 590 A1**
(43) Date of publication of application: **11.10.2017**
(21) Application number: 15864565.5
(22) Date of filing: 27.11.2015
(51) Int. Cl.: C01B 32/182

(54) **THERMALLY-CONDUCTIVE SHEET AND METHOD FOR PRODUCING SAME**

(30) Priority: 02.12.2014 JP 2014244240
(71) Applicant: Sekisui Chemical Co., Ltd., Osaka-shi, Osaka 530-8565 (JP); National University Corporation Kumamoto University, Kumamoto-shi, Kumamoto 860-8555 (JP)
(72) Inventor: NOZATO, Shoji, Mishima-gun Osaka 618-0021 (JP); NAKASUGA, Akira, Mishima-gun Osaka 618-0021 (JP); FUJIWARA, Akihiko, Mishima-gun Osaka 618-0021 (JP); IHARA, Hirotaka, Kumamoto-shi Kumamoto 860-8555 (JP); TAKAFUJI, Makoto, Kumamoto-shi Kumamoto 860-8555 (JP); SATO, Eisaku, Kumamoto-shi Kumamoto 860-8555 (JP)
(74) Representative: Ter Meer Steinmeister & Partner
(86) International application number: PCT/JP2015/083450
(87) International publication number: WO 2016/088682

(57) **Abstract**

There is provided a thermally conductive sheet having excellent thermal conductivity in the thickness direction of the sheet. A thermally conductive sheet comprising expanded graphite; and orientation-controlling particles, wherein at least part of the expanded graphite is oriented in a direction different from a plane direction of the sheet by the orientation-controlling particles.

## Description

### Technical Field

The present invention relates to a thermally conductive sheet having excellent thermal conductivity, and a method for producing the thermally conductive sheet.

### Background Art

In recent years, with the improvement of the performance of electronic equipment, the amount of heat generated has also increased, and the demand for thermally conductive sheets having excellent heat dissipation properties has increased much more. As the thermally conductive sheets having excellent heat dissipation properties, sheets using graphite having high thermal conductivity are conventionally widely known.

For example, the following Patent Literature 1 discloses an expanded graphite sheet consisting only of expanded graphite. It is described that the expanded graphite sheet of Patent Literature 1 has a thermal conductivity of 350 W/m·K or more in the plane direction.

The following Patent Literature 2 discloses a graphite sheet stack obtained by sandwiching a metal material between graphite sheets. In Patent Literature 2, the above graphite sheet stack is made by disposing a metal material between graphite sheets followed by rolling treatment.

The following Patent Literature 3 discloses a highly thermally conductive member in which metal compound particles are dispersed in an oriented graphite structure.

### Citation List

### Patent Literature

Patent Literature 1: Japanese Patent Laid-Open No. 2006-62922
Patent Literature 2: Japanese Patent Laid-Open No. 11-240706
Patent Literature 3: Japanese Patent Laid-Open No. 2005-119887

### Summary of Invention

### Technical Problem

However, the expanded graphite sheet of Patent Literature 1 has excellent thermal conductivity in the plane direction, whereas the thermal conductivity in the thickness direction is not sufficient.

In addition, in the graphite sheet stack of Patent Literature 2, the graphite sheets are subjected to rolling treatment in the production process, and therefore the graphite is oriented in the plane direction. Therefore, even if a sheet having high thermal conductivity is disposed between the graphite sheets, the thermal conductivity in the thickness direction is still insufficient.

In the highly thermally conductive member of Patent Literature 3, high thermal conductivity is obtained by mixing thermally conductive particles while maintaining the orientability of graphite, but the thermal conductivity in the thickness direction is not sufficient either.

It is an object of the present invention to provide a thermally conductive sheet having excellent thermal conductivity in the thickness direction of the sheet, and a method for producing the thermally conductive sheet.

### Solution to Problem

A thermally conductive sheet according to the present invention is a thermally conductive sheet comprising expanded graphite; and orientation-controlling particles, wherein at least part of the expanded graphite is oriented in a direction different from a plane direction of the sheet by the orientation-controlling particles.

In the thermally conductive sheet according to the present invention, preferably, at least part of the expanded graphite is oriented in the thickness direction of the sheet by the orientation-controlling particles.

The thermally conductive sheet according to the present invention preferably has a thermal conductivity of 5 W/m·K or more in the thickness direction.

In the thermally conductive sheet according to the present invention, preferably, a weight ratio of the expanded graphite to the orientation-controlling particles (expanded graphite/orientation-controlling particles) is in the range of 1/4 or more and 5 or less.

The thermally conductive sheet according to the present invention preferably has a specific gravity in the range of 1.5 g/cm³ or more and 5 g/cm³ or less.

In the thermally conductive sheet according to the present invention, preferably, the expanded graphite may be partially exfoliated graphite having a structure in which graphene is partially separated. The orientation-controlling particles may be included in the partially exfoliated graphite.

In the thermally conductive sheet according to the present invention, preferably, the orientation-controlling particles are of an inorganic compound.

In the thermally conductive sheet according to the present invention, preferably, an average particle diameter of the orientation-controlling particles is 0.2 µm or more and 1000 m or less.

A method for producing a thermally conductive sheet according to the present invention is a method for producing a thermally conductive sheet, comprising the steps of providing a mixture of expanded graphite and orientation-controlling particles; and sheet-molding the mixture by pressing to orient at least part of the expanded graphite in a direction different from a plane direction of a sheet.

In the method for producing a thermally conductive sheet according to the present invention, preferably, in the step of providing the mixture, the expanded graphite and the orientation-controlling particles are mixed in the presence of a supercritical medium.

In the method for producing a thermally conductive sheet according to the present invention, preferably, the sheet molding is performed by filling a cylinder with the mixture and pressing the mixture.

### Advantageous Effect of Invention

The thermally conductive sheet according to the present invention comprises expanded graphite and orientation-controlling particles as described above. In addition, at least part of the expanded graphite is oriented in a direction different from the plane direction of the sheet by the orientation-controlling particles. Therefore, the thermally conductive sheet according to the present invention has excellent thermal conductivity in the thickness direction of the sheet.

### Brief Description of Drawings

[Figure 1] Figure 1(a) is an SEM photograph at 600x magnification of a cross section of a thermally conductive sheet obtained in Example 1. Figure 1(b) is the element mapping image of the SEM photograph of Figure 1(a).
[Figure 2] Figure 2(a) is an SEM photograph at 2000x magnification of a cross section of the thermally conductive sheet obtained in Example 1. Figure 2(b) is the element mapping image of the SEM photograph of Figure 2(a).
[Figure 3] Figure 3(a) is an SEM photograph at 1000x magnification of a cross section of a thermally conductive sheet obtained in Comparative Example 1. Figure 3(b) is the element mapping image of the SEM photograph of Figure 3(a).

### Description of Embodiments

The details of the present invention will be described below.

### [Thermally Conductive Sheet]

A thermally conductive sheet according to the present invention comprises expanded graphite and orientation-controlling particles. At least part of the above expanded graphite is oriented in a direction different from the plane direction of the sheet by the above orientation-controlling particles. Therefore, the thermally conductive sheet according to the present invention has excellent thermal conductivity in the thickness direction of the sheet. However, when not all of the expanded graphite is oriented in a direction different from the plane direction of the sheet, the thermally conductive sheet according to the present invention also has excellent thermal conductivity in the plane direction of the sheet.

In the present invention, at least part of the above expanded graphite is preferably oriented in the thickness direction of the sheet by the above orientation-controlling particles. In this case, the thermal conductivity of the sheet in the thickness direction can be much more effectively increased.

The thermal conductivity of the thermally conductive sheet in the thickness direction is preferably 5 W/m·K or more, more preferably 7 W/m·K or more, and further preferably 10 W/m·K or more. When the thermal conductivity in the thickness direction is equal to or more than the above lower limit, the heat dissipation properties of the thermally conductive sheet can be much more increased. The upper limit of the thermal conductivity of the thermally conductive sheet in the thickness direction is not particularly limited and can be equal to or less than thermal conductivity when the expanded graphite is completely oriented in the thickness direction.

The specific gravity of the thermally conductive sheet is preferably 1.5 g/cm³ or more, more preferably 1.6 g/cm³ or more, further preferably 1.7 g/cm³ or more, and particularly preferably more than 2.0 g/cm³. The specific gravity of the thermally conductive sheet is preferably 5 g/cm³ or less, more preferably 3 g/cm³ or less, and further preferably 2.5 g/cm³ or less.

The weight ratio between the above expanded graphite and the above orientation-controlling particles (expanded graphite/orientation-controlling particles) is preferably 1/4 or more, more preferably 2/3 or more. The above weight ratio is preferably 5 or less.

When the above weight ratio (expanded graphite/orientation-controlling particles) is in the above range, the expanded graphite can be much more oriented in a direction different from the plane direction of the sheet, and the thermal conductivity in the thickness direction can be much more increased.

The components incorporated in the thermally conductive sheet according to the present invention will be described in detail below.

### (Expanded Graphite)

Expanded graphite is a stack of a plurality of graphene layers. The expanded graphite is graphite in which the distance between graphene layers is larger than in usual graphite, for example, natural graphite and synthetic graphite. As used herein, one in which the distance between at least some graphene layers is more increased than in usual graphite is included in the expanded graphite. The size of the expanded graphite is not particularly limited, but one having an average particle diameter of 100 µm to 1000 µm is preferably used. As used herein, the "average particle diameter" is a value measured by a laser diffraction/scattering type particle size distribution meter.

In the present invention, as the expanded graphite, partially exfoliated graphite may be used. The partially exfoliated graphite is graphite having a portion in which the interlayer distance between the graphenes is increased. More particularly, the partially exfoliated graphite is graphite in which the interlayer distance between the graphenes is increased, and thus some graphene stacks or graphenes are partially exfoliated from the edge to the inside to some extent.

In the partially exfoliated graphite, the interlayer distance between the graphenes is increased, and therefore its specific surface area is large. In addition, the partially exfoliated graphite is graphite in which the central portion has a graphite structure and the edge portion is exfoliated. Therefore, the partially exfoliated graphite is more easily handled than conventional graphene and exfoliated graphite. The exfoliated graphite is a stack of graphenes which is obtained by exfoliating graphite and in which the number of stacked graphenes is smaller than in the original graphite.

The partially exfoliated graphite can be obtained by a production method comprising the steps of providing a raw material composition which comprises graphite or primary exfoliated graphite and a resin and in which the resin is fixed to the graphite or primary exfoliated graphite; and pyrolyzing the resin incorporated in the above raw material composition to exfoliate the graphite or primary exfoliated graphite. A detailed production method will be described later, and the pyrolysis of the above resin may be performed while part of the resin is allowed to remain. Therefore, in the partially exfoliated graphite, part of the resin fixed to the graphite or primary exfoliated graphite by grafting or adsorption may remain.

In addition, the orientation-controlling particles may be included in the partially exfoliated graphite. More particularly, the orientation-controlling particles may be included between the graphene layers in the partially exfoliated graphite. In this case, the partially exfoliated graphite can be much more oriented in a direction different from the plane direction of the sheet, and the thermal conductivity in the thickness direction can be much more increased.

### (Orientation-Controlling Particles)

The orientation-controlling particles refer to particles that can orient at least part of the expanded graphite in a direction different from the plane direction of the sheet by their presence. The orientation-controlling particles may be of an inorganic compound or an organic compound as long as they have the above function.

When the orientation-controlling particles are of an inorganic compound, for example, aluminum oxide (Al₂O₃) or magnesium oxide (MgO) can be used.

The average particle diameter of the orientation-controlling particles is not particularly limited but is preferably 0.2 µm or more, more preferably 1 µm or more, further preferably 5 µm or more, and particularly preferably 10 µm or more. When the average particle diameter is equal to or more than the above lower limit, the expanded graphite can be much more oriented in a direction different from the plane direction of the sheet, and the thermal conductivity in the thickness direction can be much more increased.

From the viewpoint of much better sheet appearance, the average particle diameter of the orientation-controlling particles is preferably 1000 µm or less, more preferably 500 µm or less, and further preferably 300 µm or less.

### [Method for Producing Thermally Conductive Sheet]

A method for producing a thermally conductive sheet according to the present invention comprises a step of providing a mixture of expanded graphite and orientation-controlling particles (step 1); and a step of sheet-molding the above mixture to orient at least part of the above expanded graphite in a direction different from the plane direction of the sheet (step 2).

### (Step 1)

First, expanded graphite and orientation-controlling particles are mixed to provide a mixture. The mixing of the expanded graphite and the orientation-controlling particles may be performed in a dry state but is preferably performed in the presence of a supercritical medium. When the expanded graphite and the orientation-controlling particles are mixed in a supercritical medium, the expanded graphite and the orientation-controlling particles can be much more uniformly mixed. Therefore, in sheet molding described later, the expanded graphite can be much more oriented in a direction different from the plane direction of the sheet, and the heat dissipation properties of the thermally conductive sheet in the thickness direction can be much more increased. As the supercritical medium, for example, water in a supercritical state and carbon dioxide in a supercritical state (supercritical carbon dioxide) can be used.

### (Step 2)

Next, the obtained mixture is sheet-molded by pressing. At this time, the pressing of the expanded graphite is performed in the presence of the above orientation-controlling particles. Therefore, at least part of the above expanded graphite is oriented in a direction different from the plane direction of the sheet.

Therefore, from the viewpoint of much more orienting the above expanded graphite in a direction different from the plane direction of the sheet, it is preferred that in the mixture obtained in step 1, the expanded graphite and the orientation-controlling particles are uniformly mixed. Particularly, it is more preferred that the orientation-controlling particles are included between the graphene layers of the expanded graphite.

The method of sheet molding by pressing described above is not particularly limited, and, for example, the sheet can be produced by the following method. First, the obtained mixture is sandwiched between two flat plates of a metal and pressed followed by standing for a predetermined time. Thereafter, the obtained sample is heated for a predetermined time and pressed again for sheet molding. The above operation is repeated to make a plurality of sheets, and they are superimposed and pressed again to obtain a sheet having a predetermined thickness.

Also, the sheet molding may be performed by filling a cylinder with the above mixture and pressing the mixture. Also when a cylinder is used, first, the cylinder is filled with the above mixture, and the mixture is pressed and allowed to stand for a predetermined time. Thereafter, the obtained sample is heated for a predetermined time and pressed again for sheet molding.

When a cylinder is used, the cylinder can be filled with a large amount of the above mixture in the thickness direction, and therefore a sheet having thick thickness can be obtained, and a sheet having a predetermined thickness can be made in one operation. Therefore, the expanded graphite oriented in a direction different from the plane direction once is less likely to be oriented in the plane direction by another pressing. Therefore, by pressing using a cylinder, a thermally conductive sheet in which the expanded graphite is much more oriented in a direction different from the plane direction can be obtained. Therefore, the sheet molding is desirably performed by pressing using a cylinder.

In the present invention, when a thermally conductive sheet is produced, partially exfoliated graphite may be used as the expanded graphite. Also in this case, from the viewpoint of much more orienting the expanded graphite in a direction different from the plane direction of the sheet, it is preferred that the orientation-controlling particles are included inside the partially exfoliated graphite. A method for producing partially exfoliated graphite and a method for including orientation-controlling particles will be described in detail below.

### (Method for Producing Partially Exfoliated Graphite)

In the method for producing partially exfoliated graphite, first, a composition in which a resin is fixed to graphite or primary exfoliated graphite is provided. The fixation of the resin to the graphite or exfoliated graphite is performed by grafting or adsorption. The primary exfoliated graphite includes many exfoliated graphites obtained by exfoliating graphite. The primary exfoliated graphite is obtained by exfoliating graphite, and therefore its specific surface area may be larger than that of graphite.

Examples of the method of the above grafting include a method of providing a mixture comprising the above graphite or primary exfoliated graphite and a radical polymerizable monomer, and polymerizing the radical polymerizable monomer in the mixture to produce a polymer in which the above radical polymerizable monomer is polymerized in the mixture and graft the polymer, that is, a resin, on the graphite or primary exfoliated graphite.

Examples of the above radical polymerizable monomer include propylene glycol, glycidyl methacrylate, vinyl acetate, butyral, or acrylic acid.

Alternatively, a previously obtained polymer may be heated to a particular temperature range in the presence of graphite or primary exfoliated graphite to directly graft on the graphite or primary exfoliated graphite a polymer radical produced by pyrolyzing the polymer.

As the method of the above adsorption, a method of dissolving or dispersing graphite or primary exfoliated graphite and a resin in an appropriate solvent and then mixing the graphite or primary exfoliated graphite with the resin in the solvent can be used. Preferably, in order to more effectively adsorb the resin on the graphite or primary exfoliated graphite, ultrasonic treatment is desirably carried out.

Examples of the above polymer, that is, a resin, include polypropylene glycol, polyglycidyl methacrylate, polyvinyl acetate, polybutyral, or polyacrylic acid.

Next, the resin in the composition in which the resin is fixed to the graphite or primary exfoliated graphite by the above grafting or adsorption is pyrolyzed. Thus, the graphite or primary exfoliated graphite is exfoliated while part of the resin fixed to the graphite or primary exfoliated graphite is allowed to remain, and partially exfoliated graphite can be obtained. In order to perform the pyrolysis of the resin in this case, the above composition may be heated to the pyrolysis temperature of the resin or higher.

More specifically, the above composition is heated to the pyrolysis temperature of the resin or higher, and the resin is further fired. At this time, the resin is fired to the extent that the resin remains in the composition. Pyrolysis such that the resin is allowed to remain can be achieved by adjusting the heating time. In other words, by shortening the heating time, the amount of the remaining resin can be increased. By lowering the heating temperature, the amount of the remaining resin can also be increased. In this manner, the resin-remaining partially exfoliated graphite can be obtained. For the pyrolysis temperature, for example, the pyrolysis temperature of polyglycidyl methacrylate is about 400°C to 500°C.

It is considered that the partially exfoliated graphite can be obtained by the pyrolysis of the above polymer for the above-described reason, that is, because when the polymer grafted on the graphite is fired, large stress acts on the grafting point, and thus the distance between graphenes increases. The step of the above grafting, and the pyrolysis of the above polymer may be continuously carried out in the same heating step.

In the step of providing the above composition, preferably, a composition further comprising a pyrolyzable foaming agent that generates a gas in pyrolysis is provided. In this case, the graphite or primary exfoliated graphite can be much more effectively exfoliated by heating.

The above pyrolyzable foaming agent is not particularly limited as long as it is a compound that decomposes spontaneously by heating and generates a gas during the decomposition. As the above pyrolyzable foaming agent, for example, foaming agents such as azocarboxylic acid-based, diazoacetamide-based, azonitrile compound-based, benzenesulfohydrazine-based, or nitroso compound-based foaming agents that generate a nitrogen gas during decomposition, or foaming agents that generate carbon monoxide, carbon dioxide, methane, aldehyde, or the like during decomposition can be used. The above pyrolyzable foaming agent may be used alone, or a plurality of types of foaming agents may be used in combination.

Preferably, as the above pyrolyzable foaming agent, azodicarbonamide (ADCA) having a structure represented by the following formula (1) and foaming agents having structures represented by the following formulas (2) to (4) can be used. These foaming agents decompose spontaneously by heating and generate a nitrogen gas during the decomposition.

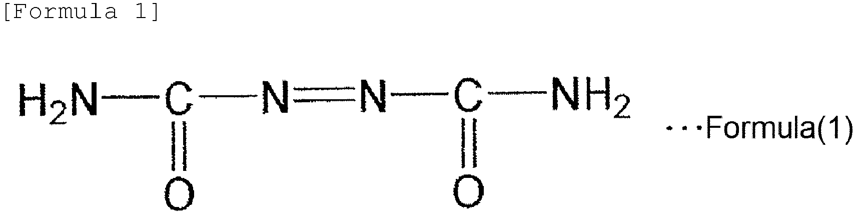

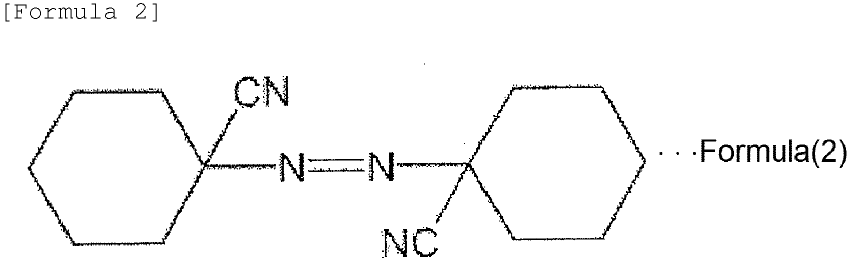

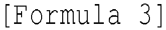

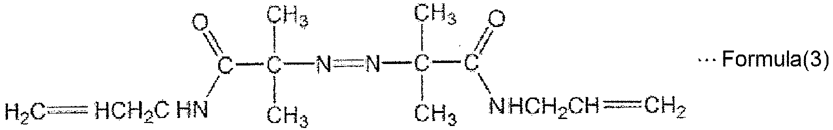

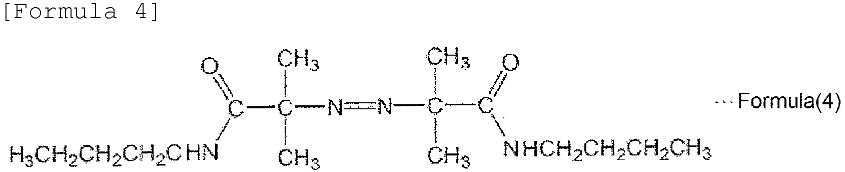

The pyrolysis temperature of the above pyrolyzable foaming agent is not particularly limited and may be lower or higher than a temperature at which the above radical polymerizable monomer spontaneously initiates polymerization. The pyrolysis temperature of the ADCA having the structure represented by the above formula (1) is 210°C, and the pyrolysis initiation temperatures of the foaming agents having the structures represented by the above formulas (2) to (4) are 88°C, 96°C, and 110°C in order.

The blending ratio between the above graphite or primary exfoliated graphite and the above pyrolyzable foaming agent is not particularly limited, but 100 parts by weight to 300 parts by weight of the above pyrolyzable foaming agent is preferably blended based on 100 parts by weight of the above graphite or primary exfoliated graphite. By setting the amount of the above pyrolyzable foaming agent blended in the above range, the above graphite or primary exfoliated graphite can be much more effectively exfoliated to effectively obtain the partially exfoliated graphite.

### (Method for Including Orientation-Controlling Particles)

In the present invention, a raw material composition comprising partially exfoliated graphite in which part of a fixed resin remains provided as described above and orientation-controlling particles is heated, and thus the orientation-controlling particles can be included in the partially exfoliated graphite.

The pyrolysis temperature of the above orientation-controlling particles is preferably higher than the pyrolysis temperature of the above resin. The heating of the above raw material composition is preferably performed at a temperature higher than the pyrolysis temperature of the above resin and lower than the pyrolysis temperature of the above orientation-controlling particles. By heating in this range, the orientation-controlling particles can be much more efficiently included in the partially exfoliated graphite. More particularly, the heating temperature is preferably in the range of about 370°C to 500°C.

### [Examples and Comparative Example]

Next, the present invention will be clarified by giving specific Examples of the present invention and a Comparative Example. The present invention is not limited to the following Examples.

### (Example 1)

71.4% by weight of expanded graphite (manufactured by SUZUHIRO CHEMICAL CO., LTD., trade name "GREP-EG," average particle diameter 100 to 2000 µm) and 28.6% by weight of Al₂O₃ (manufactured by Wako Pure Chemical Industries, Ltd., trade name "Aluminium Oxide," average particle diameter: > 75 µm) as orientation-controlling particles were placed in a pressure container (weight ratio; expanded graphite:orientation-controlling particles = 10:4) and stirred at a rate of 20 to 100 rpm by using a magnetic stirrer. Thereafter, supercritical carbon dioxide was supplied into the container, the pressure in the container was set at 27.6 MPa, and the mixture was stirred at 50°C for 6 hours. After the stirring, the supercritical carbon dioxide was extracted and the mixture of the expanded graphite and the Al₂O₃ was removed.

Next, a cylinder (size; diameter 25 mm, height 250 mm) was filled with the obtained mixture, and the mixture was pressed for 15 minutes with a pressure of 10 to 20 MPa applied. Thereafter, the mixture was heated at 500°C for 2 hours. After the heating, the mixture was pressed again in a cylinder for 15 minutes with a pressure of 30 to 40 MPa applied. Thus, a thermally conductive sheet was obtained.

### (Examples 2 to 7)

A thermally conductive sheet was obtained as in Example 1 except that the amounts of expanded graphite and orientation-controlling particles added (weight ratio), the type of the orientation-controlling particles, or the average particle diameter of the orientation-controlling particles was each set as shown in the following Table 1.

### (Example 8)

50% by weight of expanded graphite (manufactured by SUZUHIRO CHEMICAL CO., LTD., trade name "GREP-EG," average particle diameter 100 to 2000 µm) and 50% by weight of Al₂O₃ (manufactured by Wako Pure Chemical Industries, Ltd., trade name "Aluminium Oxide," average particle diameter 0.236 µm) as orientation-controlling particles were placed in a pressure container (weight ratio; expanded graphite:orientation-controlling particles = 10:10) and stirred at a rate of 20 to 100 rpm by using a magnetic stirrer. Thereafter, supercritical carbon dioxide was supplied into the container, the pressure in the container was set at 27.6 MPa, and the mixture was stirred at 50°C for 6 hours. After the stirring, the supercritical carbon dioxide was extracted and the mixture of the expanded graphite and the Al₂O₃ was removed.

Next, the obtained mixture was sandwiched between two flat plates of a metal and pressed for 15 minutes with a pressure of 10 to 20 MPa applied. Thereafter, the mixture was heated at 500°C for 2 hours. After the heating, the mixture was again sandwiched between two flat plates of a metal and pressed for 15 minutes with a pressure of 30 to 40 MPa applied to obtain a sheet. This operation was repeated a plurality of times to obtain a plurality of sheets, and they were stacked. Thereafter, the stacked sheets were sandwiched between two flat plates of a metal and pressed for 15 minutes with a pressure of 30 to 40 MPa applied to obtain a thermally conductive sheet.

### (Example 9)

### Preparation of Partially Exfoliated Graphite;

2.5 g of expanded graphite (manufactured by TOYO TANSO CO., LTD., trade name "PF Powder 8F"), 5 g of ADCA having the structure represented by formula (1) (manufactured by EIWA CHEMICAL IND. CO., LTD, trade name "AC#R-K," pyrolysis temperature 210°C) as a pyrolyzable foaming agent, and 50 g of polyglycidyl methacrylate (manufactured by NOF CORPORATION, product number "G2050M") were mixed with 450 g of tetrahydrofuran as a solvent to provide a raw material composition. The raw material composition was irradiated with ultrasonic waves at 100 W and an oscillation frequency of 28 kHz for 5 hours using an ultrasonic treatment apparatus (manufactured by Honda Electronics Co., Ltd.). The polyglycidyl methacrylate was adsorbed on the expanded graphite by the ultrasonic treatment. In this manner, a composition in which the polyglycidyl methacrylate was adsorbed on the expanded graphite was provided.

After the above ultrasonic irradiation, the above composition was molded by a solution casting method, maintained at a drying temperature of 80°C for 2 hours, then maintained at a temperature of 110°C for 1 hour, further maintained at a temperature of 150°C for 1 hour, and further maintained at a temperature of 230°C for 2 hours. Thus, the above ADCA was pyrolyzed in the above composition for foaming.

Next, the heating step of maintaining the above composition at a temperature of 450°C for 1.5 hours was carried out. Thus, the above polyglycidyl methacrylate was pyrolyzed to obtain partially exfoliated graphite. In this partially exfoliated graphite, part of the polyglycidyl methacrylate remains.

A thermally conductive sheet was obtained as in Example 1 except that the obtained partially exfoliated graphite was used as expanded graphite.

### (Example 10)

A thermally conductive sheet was obtained as in Example 9 except that the type of the orientation-controlling particles was set as shown in the following Table 1.

### (Example 11)

71.4% by weight of partially exfoliated graphite made by the same method as Example 9 and 28.6% by weight of MgO (manufactured by Wako Pure Chemical Industries, Ltd., trade name "Magnesium Oxide," average particle diameter 40 to 70 µm)) as orientation-controlling particles were placed in a pressure container (weight ratio; expanded graphite:orientation-controlling particles = 10:4) and stirred at a rate of 20 to 100 rpm by using a magnetic stirrer. After stirring at room temperature for 6 hours, the mixture of the expanded graphite and the MgO was removed. In other respects, a thermally conductive sheet was obtained as in Example 1.

### (Comparative Example 1)

A cylinder (size: diameter 25 mm, height 250 mm) was filled with 100% by weight of expanded graphite (manufactured by TOYO TANSO CO., LTD., trade name "PF powder 8F," average particle diameter 10 to 300 µm), and the expanded graphite was pressed for 15 minutes with a pressure of 10 to 20 MPa applied. Thereafter, the mixture was heated at 500°C for 2 hours. After the heating, the mixture was pressed again in a cylinder for 15 minutes with a pressure of 30 to 40 MPa applied. Thus, a thermally conductive sheet was obtained.

### (Evaluation)

### (Cross Section Observation with SEM Photograph)

A thermally conductive sheet was cut by using a diamond wire saw and its cross section was observed using a scanning electron microscope (manufactured by Hitachi High-Technologies Corporation, model number "S-3400N"). In addition, the element mapping image of the obtained scanning electron micrograph (SEM photograph) was obtained using an EDX (manufactured by Hitachi High-Technologies Corporation, model number "S-3400N").

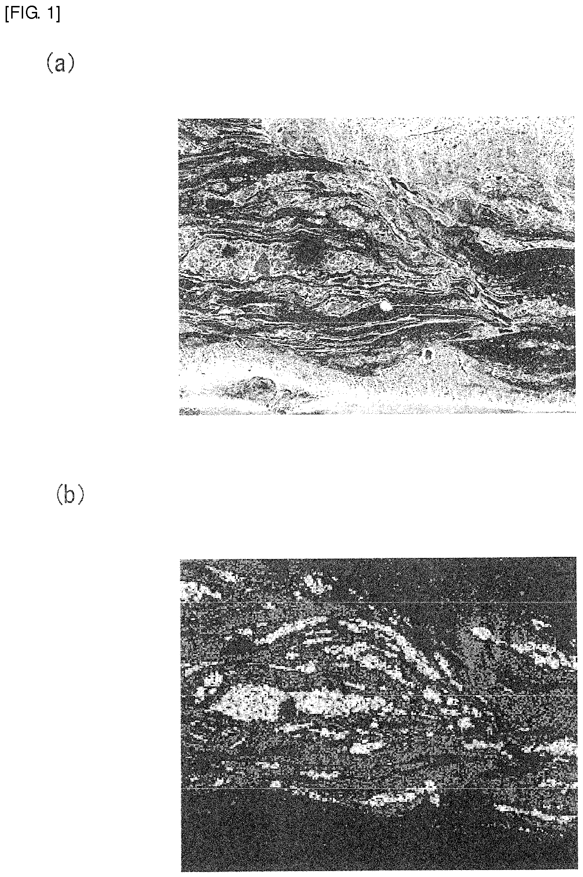

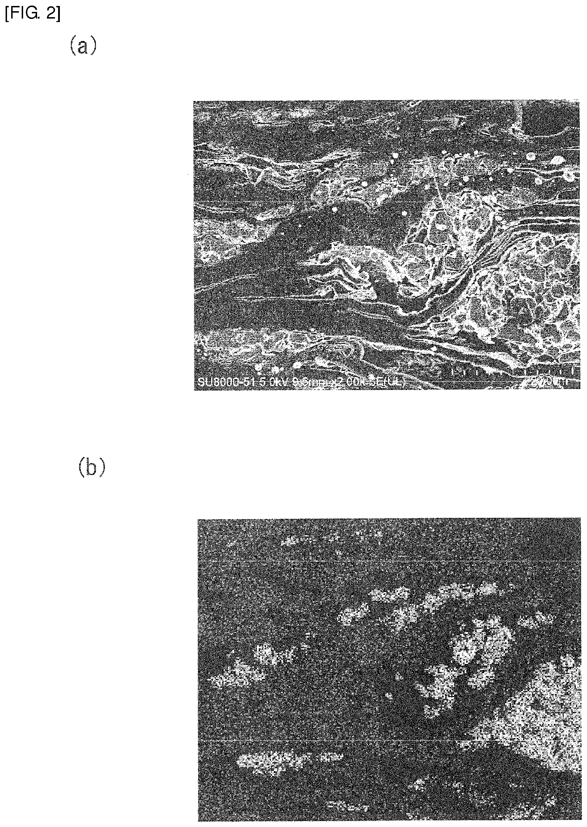

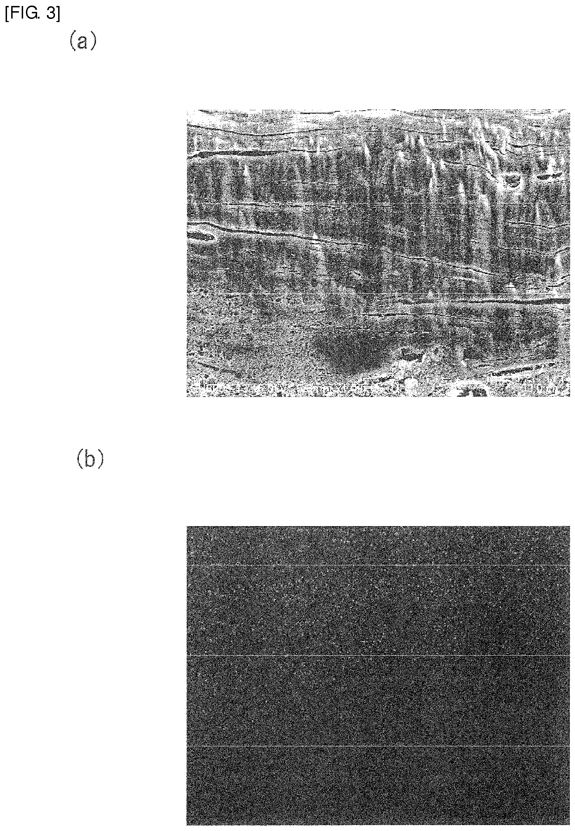

Figure 1(a) is an SEM photograph at 600x magnification of a cross section of the thermally conductive sheet obtained in Example 1. Figure 1(b) is the element mapping image of the SEM photograph of Figure 1(a). Figure 2(a) is an SEM photograph at 2000x magnification of a cross section of the thermally conductive sheet obtained in Example 1. Figure 2(b) is the element mapping image of the SEM photograph of Figure 2(a). Figure 3(a) is an SEM photograph at 1000x magnification of a cross section of the thermally conductive sheet obtained in Comparative Example 1. Figure 3(b) is the element mapping image of the SEM photograph of Figure 3(a). In the element mapping images of Figure 1(b) and Figure 2(b), the white portions represent Al, and the black portions represent carbon.

From Figure 1 to Figure 2, it is seen that in the thermally conductive sheet obtained in Example 1, at least part of the expanded graphite is oriented in a direction different from the plane direction of the sheet by the Al₂O₃, orientation-controlling particles. On the other hand, from Figure 3, it was confirmed that in the thermally conductive sheet obtained in Comparative Example 1, the expanded graphite was not oriented in a direction different from the plane direction, compared with the thermally conductive sheet of Example 1.

### (Thermal Conductivity in Thickness Direction)

The thermal conductivity of a 1 cm square thermally conductive sheet was measured using "LFA447 NanoFlash" (product number) manufactured by NETZSCH.

### (Specific Gravity)

The thickness (d) cm and weight (W) g of a 1 cm square thermally conductive sheet to be subjected to the thermal conduction measurement were measured. The specific gravity was calculated by W/(1 × 1 × d).

The results of the evaluation of the thermal conductivity in the thickness direction and the specific gravity in Examples 1 to 11 and Comparative Example 1 are shown in the following Table 1.

**[Table 1]**

| | | Ex.1 | Ex.2 | Ex.3 | Ex.4 | Ex.5 | E.x.6 | Ex.7 | Ex.8 | Ex.9 | Ex.10 | Ex.11 | Comp. Ex.1 |
|---|---|---|---|---|---|---|---|---|---|---|---|---|---|
| Amount of expanded graphite (partially exfoliated graphite) added | % by weight | 71.4 | 83.3 | 62.5 | 55.6 | 50 | 71.4 | 71.4 | 50 | 71.4 | 71.4 | 71.4 | 100 |
| Amount of orientation-controlling particles added | % by weight | 28.6 | 16.7 | 37.5 | 44.4 | 50 | 28.6 | 28.6 | 50 | 28.6 | 28.6 | 28.6 | - |
| Type of orientation-controlling particles | | Al₂O₃ | Al₂O₃ | Al₂O₃ | Al₂O₃ | Al₂O₃ | Al₂O₃ | MgO | Al₂O₃ | Al₂O₃ | MgO | MgO | - |
| Average particle diameter of orientation-controlling particles | µm | >75 | >75 | >75 | >75 | >75 | 0.236 | 40∼70 | 0.236 | >75 | 40∼70 | 40∼70 | - |
| Weight ratio expanded graphite (partially exfoliated graphite):orientation-controlling particles | | 10:4 | 10:2 | 10:6 | 10:8 | 10:10 | 10:4 | 10:4 | 10:10 | 10:4 | 10:4 | 10:4 | - |
| Supercritical carbon dioxide treatment | | Yes | Yes | Yes | Yes | Yes | Yes | Yes | Yes | Yes | Yes | No | Yes |
| Pressing method | | Cylinder | Cylinder | Cylinder | Cylinder | Cylinder | Cylinder | Cylinder | Flat plates | Cylinder | Cylinder | Cylinder | Cylinder |
| Thermal conductivity in thickness direction | W/m·K | 12.34 | 11.41 | 9.721 | 6.272 | 6.528 | 6.528 | 8.935 | 5.665 | 6.968 | 8.036 | 5.753 | 3.813 |
| Specific gravity | g/cm³ | 2.226 | 2.104 | 1.895 | 2.449 | 1.872 | 1.871 | 1.656 | 2.005 | 2.126 | 2.318 | 1.896 | 1.705 |

## Claims

1. A thermally conductive sheet comprising:
expanded graphite; and orientation-controlling particles, wherein
at least part of the expanded graphite is oriented in a direction different from a plane direction of the sheet by the orientation-controlling particles.

2. The thermally conductive sheet according to claim 1, wherein at least part of the expanded graphite is oriented in a thickness direction of the sheet by the orientation-controlling particles.

3. The thermally conductive sheet according to claim 1 or 2, having a thermal conductivity of 5 W/m·K or more in the thickness direction.

4. The thermally conductive sheet according to any one of claims 1 to 3, wherein a weight ratio of the expanded graphite to the orientation-controlling particles (expanded graphite/orientation-controlling particles) is in the range of 1/4 or more and 5 or less.

5. The thermally conductive sheet according to any one of claims 1 to 4, having a specific gravity in the range of 1.5 g/cm³ or more and 5 g/cm³ or less.

6. The thermally conductive sheet according to any one of claims 1 to 5, wherein the expanded graphite is partially exfoliated graphite having a structure in which graphene is partially separated.

7. The thermally conductive sheet according to claim 6, wherein the orientation-controlling particles are included in the partially exfoliated graphite.

8. The thermally conductive sheet according to any one of claims 1 to 7, wherein the orientation-controlling particles are of an inorganic compound.

9. The thermally conductive sheet according to any one of claims 1 to 8, wherein an average particle diameter of the orientation-controlling particles is 0.2 µm or more and 1000 µm or less.

10. A method for producing a thermally conductive sheet, comprising the steps of:
providing a mixture of expanded graphite and orientation-controlling particles; and
sheet-molding the mixture by pressing to orient at least part of the expanded graphite in a direction different from a plane direction of a sheet.

11. The method for producing a thermally conductive sheet according to claim 10, wherein in the step of providing the mixture, the expanded graphite and the orientation-controlling particles are mixed in the presence of a supercritical medium.

12. The method for producing a thermally conductive sheet according to claim 10 or 11, wherein the sheet molding is performed by filling a cylinder with the mixture and pressing the mixture.
